(19) Europäisches Patentamt
European Patent Office
Office européen des brevets

(11) **EP 3 331 040 B1**

(12) **EUROPEAN PATENT SPECIFICATION**

(45) Date of publication and mention of the grant of the patent:
**17.11.2021 Bulletin 2021/46**

(21) Application number: **16830632.2**

(22) Date of filing: **29.07.2016**

(51) Int Cl.:
***H01L 51/00*** *(2006.01)*

(86) International application number:
**PCT/JP2016/072410**

(87) International publication number:
**WO 2017/018529 (02.02.2017 Gazette 2017/05)**

(54) **SOLAR CELL AND ORGANIC SEMICONDUCTOR MATERIAL**

SOLARZELLE UND ORGANISCHES HALBLEITERMATERIAL

CELLULE SOLAIRE ET MATÉRIAU SEMI-CONDUCTEUR ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:
**30.07.2015 JP 2015150880**
**31.07.2015 JP 2015152800**
**11.03.2016 JP 2016048434**
**24.03.2016 JP 2016060853**

(43) Date of publication of application:
**06.06.2018 Bulletin 2018/23**

(73) Proprietor: **Sekisui Chemical Co., Ltd.**
**Osaka-shi, Osaka 530-0047 (JP)**

(72) Inventors:
- **HAYAKAWA, Akinobu**
  **Osaka 618-0021 (JP)**
- **YUKAWA, Mayumi**
  **Osaka 618-0021 (JP)**
- **UNO, Tomohito**
  **Osaka 618-0021 (JP)**
- **ASANO, Motohiko**
  **Osaka 618-0021 (JP)**
- **FUKUMOTO, Yuuichirou**
  **Osaka 618-0021 (JP)**
- **KUREBAYASHI, Tetsuya**
  **Osaka 618-0021 (JP)**

(74) Representative: **Cabinet Beau de Loménie**
**158, rue de l'Université**
**75340 Paris Cedex 07 (FR)**

(56) References cited:
**EP-A1- 1 925 043**
**JP-A- 2003 197 942**
**JP-A- 2013 522 868**
**JP-A- 2014 509 048**
**US-A1- 2012 098 028**

- **ANTONIO ABATE ET AL: "Protic Ionic Liquids as p-Dopant for Organic Hole Transporting Materials and Their Application in High Efficiency Hybrid Solar Cells", JOURNAL OF THE AMERICAN CHEMICAL SOCIETY, vol. 135, no. 36, 25 July 2013 (2013-07-25), pages 13538-13548, XP055134378, ISSN: 0002-7863, DOI: 10.1021/ja406230f**
- **WILLIAM H NGUYEN ET AL: "Enhancing the Hole-Conductivity of Spiro-OMeTAD without Oxygen or Lithium Salts by Using Spiro(TFSI) 2 in Perovskite and Dye- Sensitized Solar Cells", JACS, vol. 136, 22 July 2014 (2014-07-22), pages 10996-11001, XP055134459, DOI: 10.1021/ja504539w**
- **William H. Nguyen ET AL: "Supporting information: Enhancing the Hole-Conductivity of Spiro-OMeTAD without Oxygen or Lithium Salts by Using Spiro(TFSI)2 in Perovskite and Dye-Sensitized Solar Cells", JACS, 22 July 2014 (2014-07-22), pages S1-S20, XP055591234, Retrieved from the Internet: URL:https://pubs.acs.org/doi/suppl/10.1021/ja504539w/suppl_file/ja504539w_si_001.pdf [retrieved on 2019-05-23]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 331 040 B1

## Description

### TECHNICAL FIELD

The present invention relates to a solar cell having high photoelectric conversion efficiency and excellent high-temperature durability.

### BACKGROUND ART

Solar cells having a photoelectric conversion element provided with a laminate (photoelectric conversion layer) having an N-type semiconductor layer and a P-type semiconductor layer disposed between opposing electrodes have been conventionally developed. Such solar cells generate photocarriers (electron-hole pairs) by photoexcitation so that electrons and holes move through the N-type semiconductor and the P-type semiconductor, respectively, to create an electric field.

Most solar cells currently in practical use are inorganic solar cells which are produced using inorganic semiconductors such as silicon or the like. The inorganic solar cells, however, are utilized only in a limited range because their production is costly and upsizing thereof is difficult. Therefore, organic solar cells produced using organic semiconductors instead of inorganic semiconductors (see Patent Literatures 1 and 2) and organic-inorganic solar cells have received attention.

In organic solar cells or organic-inorganic solar cells, a hole transport layer is often provided between an anode and a photoelectric conversion layer that contains an N-type semiconductor and a P-type semiconductor. The hole transport layer carries out a function of improving the photoelectric conversion efficiency of the solar cell by allowing electrons and holes generated by photoexcitation to efficiently move without being recombined.

The material of the hole transport layer currently used in most cases is polyethylene dioxythiophene:polystyrene sulfonate (PEDOT:PSS) (see Patent Literature 3). However, PEDOT:PSS is soluble in water to have poor film forming properties. In addition, PEDOT:PSS is insufficient in photoelectric conversion efficiency. Moreover, PEDOT:PSS causes deterioration of the solar cell due to its strong acidity.

Therefore, the use of 2,2',7,7'-tetrakis-(N,N-dimethoxyphenyl amine)-9,9'-spirobifluorene (Spiro-OMeTAD) and trifluorosulfonyl imide-lithium salt (Li-TFSI) in combination as materials of the hole transport layer is now studied. The use of a hole transport layer containing Spiro-OMeTAD and Li-TFSI can achieve higher photoelectric conversion efficiency. In the case of using a hole transport layer containing Spiro-OMeTAD and Li-TFSI, however, the solar cell disadvantageously has poor high-temperature durability.

### CITATION LIST

- Patent Literature

Patent Literature 1: JP 2006-344794 A
Patent Literature 2: JP 4120362 B
Patent Literature 3: JP 2006-237283 A

Antonio Abate et al., "Protic Ionic Liquids as p-Dopant for Organic Hole Transporting Materials and Their Application in High Efficiency Hybrid Solar Cells", Journal of the American Chemical Society , vol. 135, no. 36, 25 July 2013, pages 13538-13548, and William Nguyen et al., "Enhancing the Hole-Conductivity of Spiro-OMeTAD without Oxygen or Lithium Salts by Using Spiro(TFSI)2 in Perovskite and Dye-Sensitized Solar Cells", JACS, vol. 136, 22 July 2014, pages 10996-11001, each show a solar cell according to the preamble of claim 1.

### SUMMARY OF INVENTION

- Technical Problem

The present invention aims to, in consideration of the state of the art, provide a solar cell having high photoelectric conversion efficiency and excellent high-temperature durability.

- Solution to problem

The present invention is defined in the claims.

The present invention is specifically described in the following.

A solar cell having a hole transport layer that contains Spiro-OMeTAD and Li-TFSI has poor high-temperature durability since a metal (lithium (Li)) precipitated in the case of using Spiro-OMeTAD and Li-TFSI in combination lowers the high-temperature durability. In a case where Li-TFSI is simply not used, however, sufficient photoelectric conversion efficiency cannot be achieved. The use of an ionic compound that contains a Spiro-OMeTAD cation and a TFSI anion can improve the photoelectric conversion efficiency while allowing maintenance of the high-temperature durability.

In the case of a hole transport layer containing an ionic compound that contains a Spiro-OMeTAD cation and a TFSI anion, the metal concentration of the hole transport layer affects the photoelectric conversion efficiency. When the metal concentration of the hole transport layer is set to 1000 ppm or lower, higher photoelectric conversion efficiency can be achieved.

The present inventors further found out that the high-temperature durability is also improved in the case where a different organic semiconductor is used instead of a spiro compound such as Spiro-OMeTAD. However, they also found out that when a different organic semiconductor and Li-TFSI are used in combination, a metal (lithium (Li)) is precipitated so that the carrier density cannot be sufficiently increased due to the precipitated metal as a dopant, leading to reduction in the photoelectric conversion efficiency. When an ionic compound that contains an organic semiconductor cation and a TFSI anion is used and the metal concentration of the hole transport layer is set to 1000 ppm or lower, the photoelectric conversion efficiency can be improved while the high-temperature durability is maintained.

The solar cell of the present invention has an electrode, a counter electrode, a photoelectric conversion layer disposed between the electrode and the counter electrode, and a hole transport layer disposed between the photoelectric conversion layer and the counter electrode.

The term "layer" as used herein means not only a layer having a clear boundary, but even a layer having a concentration gradient in which contained elements are gradually changed. The elemental analysis of the layer can be conducted, for example, by FE-TEM/EDS analysis of a cross section of the solar cell to confirm the element distribution of a particular element. The term "layer" as used herein means not only a flat thin film-like layer, but also a layer capable of forming an intricate structure together with other layer(s).

The hole transport layer contains an ionic compound that contains an organic semiconductor cation and a fluorine-containing compound anion (hereafter, also simply referred to as an "ionic compound"). The use of a hole transport layer containing such an ionic compound enables the solar cell of the present invention to achieve both the photoelectric conversion efficiency and the high-temperature durability.

An organic semiconductor cation is a spiro compound cation represented by the following formula (1), a polytriphenylamine compound cation represented by the following formula (3), or a thiophene compound cation having a structure represented by the following formula (4). The present invention uses a polytriphenylamine compound cation represented by the formula (3), or a thiophene compound cation having a structure represented by the formula (4), and a fluorine-containing compound anion.

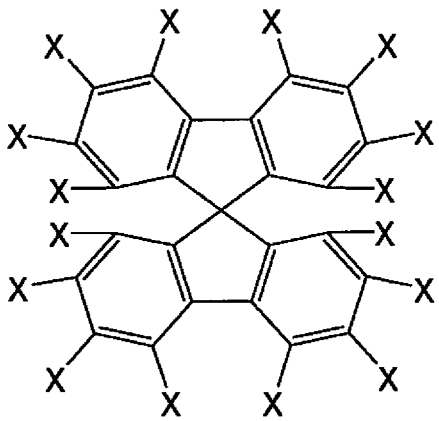

(1)

In the formula (1), at least one X represents a group represented by the following formula (2).

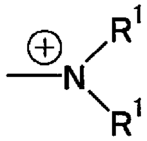

(2)

In the formula (2), $R^1$ represents hydrogen, an alkyl group, an aryl group optionally having a substituent, a carboxyl group, a carbonyl group, an alkoxy group, an ester group, or an amino group, and one $R^1$ and the other $R^1$ may be bonded to each other to form a ring structure.

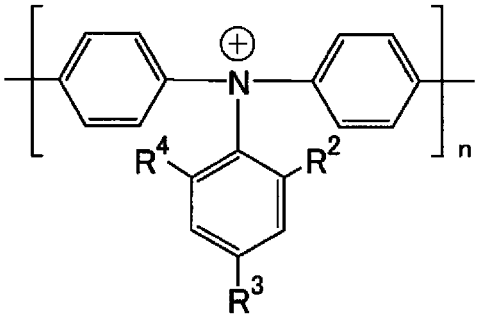

(3)

In the formula (3), $R^2$, $R^3$, and $R^4$ each represent hydrogen, an alkyl group, an aryl group optionally having a substituent, a carboxyl group, a carbonyl group, an alkoxy group, an ester group, or an amino group, and any of $R^2$, $R^3$, and $R^4$ may be bonded to each other to form a ring structure, and n represents an integer. Preferably, n is an integer of 10 or more.

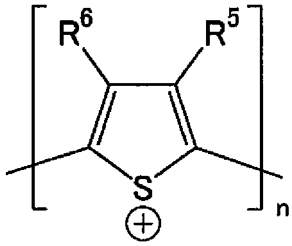

(4)

In the formula (4), $R^5$ and $R^6$ each represent hydrogen, an alkyl group, an aryl group optionally having a substituent, a carboxyl group, a carbonyl group, an alkoxy group, an ester group, or an amino group, and $R^5$ and $R^6$ may be bonded to each other to form a ring structure, and n represents an integer.

In the spiro compound cation represented by the formula (1), at least one X is a group represented by the formula (2). The cation of that group causes ionic bonding between the spiro compound cation represented by the formula (1) and the fluorine-containing compound anion to generate the ionic compound.

In the spiro compound cation represented by the formula (1), Xs other than the group represented by the formula (2) are not particularly limited and are each preferably a group represented by the following formula (2') or hydrogen.

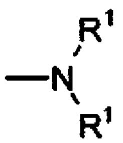

(2')

In the formula (2'), $R^1$ represents hydrogen, an alkyl group, an aryl group optionally having a substituent, a carboxyl group, a carbonyl group, an alkoxy group, an ester group, or an amino group, and one $R^1$ and the other $R^1$ may be bonded to each other to form a ring structure.

The polytriphenylamine compound cation represented by the formula (3) is not particularly limited as long as it is represented by the formula (3), and may be a cation of a polytriphenylamine compound commonly used as a material of a solar cell. Not all the constitutional units represented by the formula (3) are required to be cations, provided that the constitutional units represented by the formula (3) are partially cations and the polytriphenylamine compound is cationic

as a whole.

The thiophene compound cation having a structure represented by the formula (4) may be a low-molecular compound or a high-molecular compound as long as it has a structure represented by the formula (4). In the case of a high-molecular compound, not all the constitutional units represented by the formula (4) are required to be cations, provided that the constitutional units represented by the formula (4) are partially cations and the thiophene compound is cationic as a whole. The thiophene compound cation having a structure represented by the formula (4) is not particularly limited as long as it has a structure represented by the formula (4), and may be a cation of a thiophene compound commonly used as a material of a solar cell.

The fluorine-containing compound anion is not particularly limited as long as it can form a stable ionic compound together with the organic semiconductor cation. Preferably, the fluorine-containing compound anion is an anion represented by the following formula (5-1), an anion represented by the following formula (5-2), an anion represented by the following formula (5-3), an anion represented by the following formula (5-4), an anion represented by the following formula (5-5), or an anion represented by the following formula (5-6).

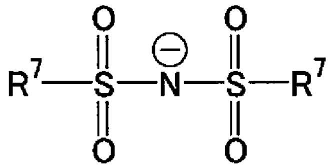
(5-1)

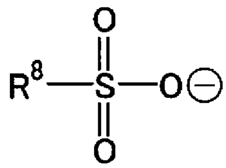
(5-2)

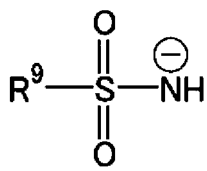
(5-3)

$PF_5^-$ (5-4)

$BF_4^-$ (5-5)

$SbF_6^-$ (5-6)

In the formulae (5-1) to (5-3), $R^7$ to $R^9$ each represent an alkyl group partially or entirely substituted with fluorine. In the formula (5-1), one $R^7$ and the other $R^7$ may be bonded to each other to form a ring structure.

The lower limit of the amount of the ionic compound in the hole transport layer is preferably 1% by weight. When the amount of the ionic compound is 1% by weight or more, still higher high-temperature durability and still higher photoelectric conversion efficiency can be both achieved. The lower limit of the amount of the ionic compound in the hole transport layer is more preferably 5% by weight, still more preferably 10% by weight.

The upper limit of the amount of the ionic compound in the hole transport layer is not particularly limited. From the standpoint of forming a uniform film, the upper limit is preferably 100% by weight, more preferably 50% by weight, still more preferably 30% by weight.

In a case where a hole transport layer contains an ionic compound that contains a spiro compound cation represented by the formula (1) and a fluorine-containing compound anion, a hole transport layer further containing a spiro compound represented by the formula (1') can achieve still higher photoelectric conversion efficiency.

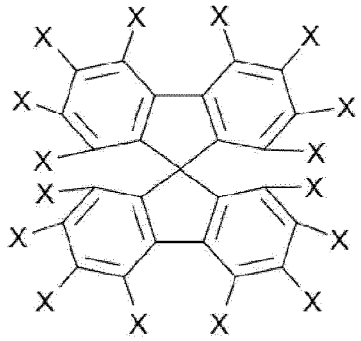

(1')

In the formula (1'), at least one X represents a group represented by the following formula (2').

In the spiro compound represented by the formula (1'), Xs other than the group represented by the formula (2') are not particularly limited and are each preferably hydrogen.

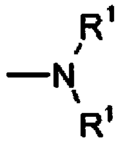

(2')

In the formula (2'), $R^1$ represents hydrogen, an alkyl group, an aryl group optionally having a substituent, a carboxyl group, a carbonyl group, an alkoxy group, an ester group, or an amino group, and one $R^1$ and the other $R^1$ may be bonded to each other to form a ring structure.

The hole transport layer has a metal concentration of 1000 ppm or lower. In this case, the solar cell of the present invention can exhibit high photoelectric conversion efficiency.

Though not clear, the reason for this is presumably as follows. In a case where a metal is present in the hole transport layer, the carrier density cannot be sufficiently increased due to the metal as a dopant, leading to lower photoelectric conversion efficiency. By setting the metal concentration to a certain level or lower, such a situation can be reduced. The upper limit of the metal concentration of the hole transport layer is preferably 100 ppm, more preferably 10 ppm. The metal concentration can be measured using a device such as ICP-MS available from Shimadzu Corporation.

The metal in the hole transport layer is mainly derived from a fluorine-containing compound anion/metal cation salt that is a raw material for obtaining the ionic compound that contains an organic semiconductor cation and a fluorine-containing compound anion. Specifically, in the case where a fluorine-containing compound anion/metal cation salt used as a raw material is a silver salt, for example, the silver concentration of the hole transport layer is to be considered.

The metal concentration of the hole transport layer may be set to 1000 ppm or lower by any method. In a preferred method, an organic semiconductor and a fluorine-containing compound anion/metal cation salt to be used as raw materials are reacted in advance to prepare the ionic compound, and then a free metal is recovered to be removed. In this case, the fluorine-containing compound anion/metal cation salt to be used as a raw material is preferably a silver salt. The use of a salt of silver having low ionization tendency enables easy precipitation of silver, facilitating recovery and removal of the silver.

More specifically, a solution of an organic semiconductor in dichloromethane is blended with a fluorine-containing compound anion/silver salt to be reacted, thereby providing the ionic compound. In this process, silver is precipitated, and the precipitated silver is separated. Then, the solution is concentrated to prepare the ionic compound. The obtained ionic compound is dissolved in an organic solvent to prepare a solution, and the solution is applied by a method such as spin coating to form a hole transport layer with a metal concentration of 1000 ppm or lower.

The lower limit of the thickness of the hole transport layer is preferably 1 nm and the upper limit thereof is preferably 2000 nm. With a thickness of 1 nm or more, the hole transport layer can sufficiently block electrons. With a thickness 2000 nm or less, the hole transport layer is less likely to be the resistance to the hole transport, enhancing the photoelectric conversion efficiency. The lower limit of the thickness of the hole transport layer is more preferably 3 nm, and the upper limit thereof is more preferably 1000 nm. The lower limit is still more preferably 5 nm and the upper limit is still more preferably 500 nm.

The photoelectric conversion layer is not particularly limited, and preferably contains an organic-inorganic perovskite compound represented by the formula: $R\text{-}M\text{-}X_3$ (where R represents an organic molecule, M represents a metal atom, and X represents a halogen atom or a chalcogen atom. The solar cell having the photoelectric conversion layer containing the organic-inorganic perovskite compound is also referred to as an organic-inorganic hybrid solar cell.

When the photoelectric conversion layer contains the organic-inorganic perovskite compound, the solar cell

can have better photoelectric conversion efficiency. Since the organic-inorganic perovskite compound has poor humidity resistance, in the case where the photoelectric conversion layer contains the organic-inorganic perovskite compound, it is more effective to dispose an encapsulation resin layer as described later and an inorganic layer on the counter electrode for better durability of the solar cell.

R is an organic molecule and is preferably represented by $C_lN_mH_n$ (1, m, and n are each a positive integer).

Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, formamidine, acetoamidine, guanidine, imidazole, azole, pyrrole, aziridine, azirine, azetidine, azete, azole, imidazoline, carbazole, ions of these (e.g., methylammonium($CH_3NH_3$))), and phenethylammonium. Preferred among these are methylamine, ethylamine, propylamine, butylamine, pentylamine, hexylamine, formamidine, acetoamidine, ions of these, and phenethylammonium. More preferred are methylamine, ethylamine, propylamine, and ions of these.

M is a metal atom, and examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. These metal atoms may be used alone or two or more of these may be used in combination.

X is a halogen atom or a chalcogen atom, and examples thereof include chlorine, bromine, iodine, sulfur, and selenium. These halogen atoms or chalcogen atoms may be used alone or two or more of these may be used in combination. Preferred among these is a halogen atom because the organic-inorganic perovskite compound containing halogen in the structure is soluble in an organic solvent to be usable in an inexpensive printing method or the like. More preferred is iodine because the organic-inorganic perovskite compound has a narrower energy band gap.

The organic-inorganic perovskite compound preferably has a cubic crystal structure where the metal atom M is placed at the body center, the organic molecule R is placed at each vertex, and the halogen atom or chalcogen atom X is placed at each face center.

Fig. 1 is a schematic view illustrating an exemplary crystal structure of the organic-inorganic perovskite compound having a cubic crystal structure where the metal atom M is placed at the body center, the organic molecule R is placed at each vertex, and the halogen atom or chalcogen atom X is placed at each face center. Although details are not clear, it is presumed that the direction of an octahedron in the crystal lattice can be easily changed owing to the structure; thus the mobility of electrons in the organic-inorganic perovskite compound is enhanced, improving the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution. When the organic-inorganic perovskite compound is a crystalline semiconductor, the mobility of electrons in the organic-inorganic perovskite compound is enhanced, improving the photoelectric conversion efficiency of the solar cell.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. When the degree of crystallinity is 30% or higher, the mobility of electrons in the organic-inorganic perovskite compound is enhanced, improving the photoelectric conversion efficiency of the solar cell. The lower limit of the degree of crystallinity is more preferably 50%, further preferably 70%.

Examples of the method for increasing the degree of crystallinity of the organic-inorganic perovskite compound include heat annealing, irradiation with light having strong intensity, such as laser, and plasma irradiation.

In the case where the photoelectric conversion layer contains the organic-inorganic perovskite compound, the photoelectric conversion layer may contain, in addition to the organic-inorganic perovskite compound, an organic semiconductor or an inorganic semiconductor within a range that does not impair the effect of the present invention. The organic semiconductor or inorganic semiconductor as used herein may serve as an electron transport layer or a hole transport layer.

Examples of the organic semiconductor include compounds having a thiophene skeleton, such as poly(3-alkylthiophene). Examples thereof also include conductive polymers having a poly-p-phenylenevinylene skeleton, a polyvinylcarbazole skeleton, a polyaniline skeleton, a polyacetylene skeleton or the like. Examples thereof further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene, which may be surface-modified.

Examples of the inorganic semiconductor include titanium oxide, zinc oxide, indium oxide, tin oxide, gallium oxide, tin sulfide, indium sulfide, zinc sulfide, CuSCN, $Cu_2O$, CuI, $MoO_3$, $V_2O_5$, $WO_3$, $MoS_2$, $MoSe_2$, and $Cu_2S$.

In the case of containing the organic-inorganic perovskite compound and the organic semiconductor or inorganic semiconductor, the photoelectric conversion layer may be a laminate in which a thin film-like organic semiconductor or inorganic semiconductor part and a thin film-like organic-inorganic perovskite compound part are laminated, or a composite film in which an organic semiconductor or inorganic semiconductor part and an organic-inorganic perovskite compound part are combined. The laminate is preferred from the viewpoint that the production process is simple. The composite film is preferred from the viewpoint that the charge separation efficiency of the organic semiconductor or inorganic semiconductor can be improved.

The lower limit of the thickness of the thin film-like organic-inorganic perovskite compound part is preferably 5 nm and the upper limit thereof is preferably 5000 nm. With a thickness of 5 nm or more, the part can sufficiently absorb light to improve the photoelectric conversion efficiency. With a thickness of 5000 nm or less, formation of a region in which charge separation cannot be achieved can be suppressed, leading to higher photoelectric conversion efficiency. The lower limit is more preferably 10 nm and the upper limit is more preferably 1000 nm. The lower limit is still more preferably 20 nm and the upper limit is still more preferably 500 nm.

In the case where the photoelectric conversion layer is a composite film in which an organic semiconductor or inorganic semiconductor part and an organic-inorganic perovskite compound part are combined, the lower limit of the thickness of the composite film is preferably 30 nm and the upper limit thereof is preferably 3000 nm. With a thickness of 30 nm or more, the photoelectric conversion layer can sufficiently absorb light, enhancing the photoelectric conversion efficiency. With a thickness of 3000 nm or less, charge easily arrives at the electrode, enhancing the photoelectric conversion efficiency. The lower limit of the thickness is more preferably 40 nm and the upper limit is more preferably 2000 nm. The lower limit is still more preferably 50 nm and the upper limit is still more preferably 1000 nm.

Examples of the method for forming the photoelectric conversion layer include, but are not particularly limited to, a vapor deposition method, a sputtering method, a chemical vapor deposition (CVD) method, an electrochemical deposition method, and a printing method. Among them, employment of a printing method allows simple formation of a large-area solar cell that can exhibit high photoelectric conversion efficiency. Examples of the printing method include a spin coating method and a casting method. Examples of the method using the printing method include a roll-to-roll method.

The solar cell of the present invention may have an electron transport layer on the opposite side of the hole transport layer across the photoelectric conversion layer. Examples of the material of the electron transport layer include, but are not particularly limited to, N-type conductive polymers, N-type low-molecular organic semiconductors, N-type metal oxides, N-type metal sulfides, alkali metal halides, alkali metals, and surfactants. Specific examples thereof include cyano group-containing polyphenylenevinylene, boron-containing polymers, bathocuproine, bathophenanthrene, hydroxyquinolinato aluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin film-like electron transport layer and preferably includes a porous electron transport layer. In particular, when the photoelectric conversion layer is a composite film in which an organic semiconductor or inorganic semiconductor part and an organic-inorganic perovskite compound part are combined, a composite film is preferably formed on a porous electron transport layer because a more complicated composite film (more intricate structure) is obtained, enhancing the photoelectric conversion efficiency.

The lower limit of the thickness of the electron transport layer is preferably 1 nm, and the upper limit thereof is preferably 2000 nm. With a thickness of 1 nm or more, the electron transport layer can sufficiently block holes. With a thickness of 2000 nm or less, the electron transport layer is less likely to be the resistance to the electron transport, enhancing the photoelectric conversion efficiency. The lower limit of the thickness of the electron transport layer is more preferably 3 nm and the upper limit thereof is more preferably 1000 nm. The lower limit is still more preferably 5 nm and the upper limit is still more preferably 500 nm.

The material of the electrode and the counter electrode is not particularly limited, and a conventionally known material may be used. The counter electrode is a patterned electrode in many cases.

Examples of the material of the electrode and the counter electrode include fluorine-doped tin oxide (FTO), sodium, sodium-potassium alloys, lithium, magnesium, aluminum, magnesium-silver mixtures, magnesium-indium mixtures, aluminum-lithium alloys, $Al/Al_2O_3$ mixtures, Al/LiF mixtures, metals such as gold, conductive transparent materials such as CuI, indium tin oxide (ITO), $SnO_2$, aluminum zinc oxide (AZO), indium zinc oxide (IZO), and gallium zinc oxide (GZO), and conductive transparent polymers. These materials may be used alone or may be used in combination of two or more thereof.

The electrode and the counter electrode may be either a cathode or an anode.

The solar cell of the present invention preferably has an encapsulation resin layer covering the counter electrode. The encapsulation resin layer preferably encapsulates a laminate having at least the electrode, the counter electrode, the photoelectric conversion layer disposed between the electrode and the counter electrode, and the hole transport

layer disposed between the photoelectric conversion layer and the counter electrode. The encapsulation resin layer suppresses moisture penetration into the inside, thereby improving the durability of the solar cell.

The encapsulation resin layer preferably covers the laminate entirely so as to close the end portions thereof. This can reliably prevent moisture penetration into the inside.

The encapsulation resin layer is preferably formed of a resin having a solubility parameter (SP value) of 10 or less. The use of an encapsulation resin layer formed of such a resin improves the high-temperature durability of the resulting solar cell.

The reason for this is not clear but is presumably that, while a conventional resin unintendedly allows dispersion of the ionic compound in the hole transport layer into the encapsulation resin, a resin with a solubility parameter (SP value) of 10 or less can prevent such dispersion.

The SP value is called the solubility parameter and is an index capable of showing ease of dissolution. The SP value herein can be determined by a method proposed by Fedors (R.F. Fedors, Polym. Eng. Sci., 14 (2), 147-154 (1974)), and calculated according to the equation (1) given below based on the evaporation energy ($\Delta$ecoh) (cal/mol) and molar volume ($\Delta$v) ($cm^3$/mol) of each atomic group in repeating units or the structure. In the equation (1), $\delta$ represents the SP value $(cal/mol)^{1/2}$.

$$\delta = \sqrt{\frac{\sum \Delta ecoh}{\sum \Delta v}} \qquad (1)$$

Values described in J. Brandrup et al., "Polymer Handbook, Fourth Edition", volume 2 can be used as $\Delta$ecoh and $\Delta$v.

In the case of $Tg \geq 25°C$, 2n (n represents the number of main chain atoms) is added to $\Delta$v when $n \geq 3$ is satisfied and 4n is added to $\Delta$v when $n < 3$ is satisfied for the calculation.

The SP value of the copolymer can be calculated according to the equation (2) given below using the SP value of each repeating unit alone in the copolymer, which is calculated in advance, and the volume fraction thereof. In the equation (2), $\delta$cop represents the SP value of the copolymer, $\phi_1$ and $\phi_2$ represent the respective volume fractions of repeating units 1 and 2, and $\delta_1$ and $\delta_2$ represent the respective SP values of the repeating units 1 and 2.

$$\delta cop^2 = \phi_1 \delta_1^2 + \phi_2 \delta_2^2 \qquad (2)$$

The resin having a solubility parameter (SP value) of 10 or less is not particularly limited and may be, for example, silicone resin (SP value: about 7.5), polyolefin resin (SP value: about 8), butyl rubber (SP value: about 8), Teflon (®) resin (SP value: about 7.5), polyisobutylene (SP value: about 7.5), or acrylic resin (SP value: about 9.5). In particular, the resin is preferably silicone resin, polyolefin resin, butyl rubber, or polyisobutylene because they each have a favorable SP value.

Epoxy resin that is commonly used as an encapsulation resin for solar cells has a solubility parameter (SP value) of about 10.5, which does not fall within the above range of the solubility parameter (SP value).

The SP value can be adjusted within a favorable range by blending two materials having different SP values within an appropriate range, by selecting a monomer having an appropriate skeleton for a monomer used in polymerization, or by addition-reacting a reactive compound having an appropriate skeleton.

The resin having a solubility parameter (SP value) of 10 or less preferably contains a resin having an alicyclic skeleton. The resin having a solubility parameter (SP value) of 10 or less may be a mixture of the resin having an alicyclic skeleton and a resin not having an alicyclic skeleton.

The alicyclic skeleton is not particularly limited, and examples thereof include norbornene, isobornene, adamantane, cyclohexane, dicyclopentadiene, dicyclohexane, and cyclopentane skeletons. These skeletons may be used alone or in combination of two or more thereof.

The resin having an alicyclic skeleton is not particularly limited as long as it has an alicyclic skeleton. It may be a thermoplastic resin, a thermosetting resin, or a photocurable resin. These resins having an alicyclic skeleton may be used alone or in combination of two or more thereof.

The resin having an alicyclic skeleton may be a resin prepared by forming a resin having a reactive functional group into a film and then crosslinking the reactive functional group.

Examples of the resin having an alicyclic skeleton include norbornene resin (TOPAS9014, available from Polyplastics Co., Ltd.) and polymers of adamantane acrylate (available from Mitsubishi Gas Chemical Company).

The lower limit of the thickness of the encapsulation resin layer is preferably 100 nm and the upper limit thereof is preferably 100000 nm. The lower limit of the thickness is more preferably 500 nm and the upper limit thereof is more

preferably 50000 nm. The lower limit is still more preferably 1,000 nm and the upper limit is still more preferably 20000 nm.

The solar cell of the present invention preferably further has an inorganic layer containing a metal oxide, metal nitride, or metal oxynitride, on the encapsulation resin layer. Since the inorganic layer has high water vapor barrier properties to further suppress moisture penetration into the inside, the solar cell with such a configuration has further enhanced durability.

The metal oxide, metal nitride, or metal oxynitride is not particularly limited as long as it has water vapor barrier properties, and may be, for example, an oxide, nitride, or oxynitride of Si, Al, Zn, Sn, In, Ti, Mg, Zr, Ni, Ta, W, Cu, or an alloy containing two or more of these. Among these, preferred is an oxide, nitride, or oxynitride of Si, Al, Zn, or Sn, and more preferred is an oxide, nitride, or oxynitride of Zn or Sn. In terms of providing the inorganic layer with particularly high water vapor barrier properties and flexibility, still more preferred is an oxide, nitride, or oxynitride of metal elements including both Zn and Sn.

In particular, the metal oxide, metal nitride, or metal oxynitride is preferably a metal oxide represented by the formula: $Zn_aSn_bO_c$. In the formula, a, b, and c each represent a positive integer.

Use of a metal oxide represented by the formula: $Zn_aSn_bO_c$ in the inorganic layer can impart moderate flexibility to the inorganic layer because the metal oxide contains a tin (Sn) atom, so that stress is decreased even when the thickness of the inorganic layer is increased. Therefore, peeling of the inorganic layer from the encapsulation resin layer can be suppressed. This can enhance the water vapor barrier properties of the inorganic layer and further improve the durability of the solar cell. Meanwhile, the inorganic layer can exhibit a particularly high barrier properties because the metal oxide contains a zinc (Zn) atom.

In the metal oxide represented by the formula: $Zn_aSn_bO_c$, the ratio Xs (% by weight) of Sn to the total sum of Zn and Sn preferably satisfies $70 > Xs > 0$. Also, a value Y represented by $Y = c/(a + 2b)$ preferably satisfies $1.5 > Y > 0.5$.

The element ratio of zinc (Zn), tin (Sn), and oxygen (O) contained in the metal oxide represented by the formula: $Zn_aSn_bO_c$ in the inorganic layer can be measured using an X-ray photoemission spectroscopy (XPS) surface analyzer (e.g., ESCALAB-200R available from VG Scientific).

Preferably, the inorganic layer containing the metal oxide represented by the formula: $Zn_aSn_bO_c$ further contains silicon (Si) and/or aluminum (Al).

The addition of silicon (Si) and/or aluminum (Al) to the inorganic layer can enhance the transparency of the inorganic layer and improve the photoelectric conversion efficiency of the solar cell.

The lower limit of the thickness of the inorganic layer is preferably 30 nm, and the upper limit thereof is preferably 3000 nm. With a thickness of 30 nm or more, the inorganic layer can have sufficient water vapor barrier properties, improving the durability of the solar cell. With a thickness of 3000 nm or less, only small stress is generated even when the thickness of the inorganic layer is increased. Therefore, peeling of the inorganic layer, electrode, semiconductor layer, and the like can be suppressed. The lower limit of the thickness is more preferably 50 nm and the upper limit thereof is more preferably 1000 nm. The lower limit is still more preferably 100 nm and the upper limit is still more preferably 500 nm.

The thickness of the inorganic layer can be measured using an optical interference-type film thickness measurement apparatus (e.g., FE-3000 available from Otsuka Electronics Co., Ltd.).

In the solar cell of the present invention, the encapsulation resin may be further covered with, for example, an additional material such as a glass sheet, resin film, inorganic material-coated resin film, or metal (e.g., aluminum) foil. This can sufficiently block water vapor even when a pinhole is present in the encapsulation resin layer, and can further improve the durability of the solar cell. In particular, an inorganic material-coated resin film is more preferably disposed.

The solar cell of the present invention may further have a substrate and the like. Examples of the substrate include, but are not particularly limited to, transparent glass substrates such as soda-lime glass and alkali-free glass substrates, ceramic substrates, and transparent plastic substrates.

Examples of the method for producing the solar cell of the present invention include, but are not particularly limited to, a method which involves forming the electrode, the electron transport layer, the photoelectric conversion layer, the hole transport layer, and the counter electrode in this order on the substrate to prepare a laminate and then encapsulating the laminate with the encapsulation resin layer.

Examples of the method for encapsulating the laminate with the encapsulation resin include, but are not particularly limited to, a method which involves sealing the laminate using a sheet-shaped encapsulation resin, a method which involves applying an encapsulation resin solution containing the encapsulation resin dissolved in an organic solvent to the laminate, a method which involves applying a compound having a reactive functional group to be the encapsulation resin to the laminate, followed by cross-linking or polymerization of the compound having a reactive functional group using heat, UV, or the like, and a method which involves melting the encapsulation resin under heat, followed by cooling.

- Advantageous Effects of Invention

The present invention can provide a solar cell having high photoelectric conversion efficiency and excellent

high-temperature durability.

BRIEF DESCRIPTION OF DRAWINGS

Fig. 1 is a schematic view illustrating an exemplary crystal structure of an organic-inorganic perovskite compound.

DESCRIPTION OF EMBODIMENTS

Hereinafter, the present invention will be described in more detail with reference to the following Examples 6 to 12, Examples 1 to 5 and 13 being reference examples. However, the present invention is defined in the claims.

(Reference Example 1)

(1) Production of a laminate in which an electrode, an electron transport layer, a photoelectric conversion layer, and a counter electrode are stacked A FTO film having a thickness of 1000 nm was formed as an electrode on a glass substrate, ultrasonically washed with pure water, acetone, and methanol each for ten minutes in the stated order, and then dried.

A solution of titanium isopropoxide in ethanol adjusted to 2% was applied to the surface of the FTO film by the spin coating method and then fired at 400°C for 10 minutes to form a thin film-like electron transport layer having a thickness of 20 nm. A titanium oxide paste containing polyisobutyl methacrylate as an organic binder and titanium oxide (mixture of powders having average particle sizes of 10 nm and 30 nm) was further applied to the thin film-like electron transport layer by the spin coating method and then fired at 500°C for 10 minutes to form a porous electron transport layer having a thickness of 500 nm.

Separately, lead iodide was reacted with dimethyl sulfoxide (DMSO) in advance to prepare a lead iodide-dimethyl sulfoxide complex. The lead iodide-dimethyl sulfoxide complex was dissolved in N,N-dimethylformamide (DMF) at a concentration of 40% by weight to prepare a coating solution.

On the electron transport layer was laminated the obtained coating solution by the spin coating method to a thickness of 500 nm, and an 8% solution of methylammonium iodide in isopropanol was applied thereto by the spin coating method so that the coating solution was reacted. A photoelectric conversion layer containing an organic-inorganic perovskite compound was thus formed.

Next, 0.25 g of 2,2',7,7'-tetrakis-(N,N-dimethoxyphenyl amine)-9,9'-spirobifluorene (Spiro-OMeTAD, available from Merck KGaA) and 0.17 g of silver trifluorosulfonyl imide(Ag-TFSI, available from Aldrich) were dissolved in 25 mL of dichloromethane, and stirred at 500 rpm for one day. The resulting solution was passed through a 1-μm mesh to separate precipitates, and the recovered solution was concentrated using an evaporator. The resulting concentrate was recrystallized using diethyl ether, thereby preparing an ionic compound containing a Spiro-OMeTAD cation and a TFSI anion.

An amount of 1 mg of the obtained ionic compound and 9 mg of the Spiro-OMeTAD were dissolved in 100 μL of chlorobenzene, and the obtained solution was applied by the spin coating method to form a hole transport layer containing 10% by weight of the ionic compound.

The presence of the ionic bond formed by Spiro-OMeTAD and TFSI was confirmed as follows. The absorption spectrum was measured to find a shift of the absorption to the long wavelength side in comparison to the spectrum of the sample in which no ionic bond was formed. The metal concentration (silver concentration) of the hole transport layer measured by ICP-MS was 800 ppm.

On the obtained hole transport layer were formed an Au film with a thickness of 100 nm as a counter electrode by vacuum deposition. Thus, a laminate in which an electrode, an electron transport layer, a photoelectric conversion layer, a hole transport layer, and a counter electrode were stacked was obtained.

(2) Encapsulation with an encapsulation resin layer

A solution of polyisobutylene resin (OPPANOL 100 available from BASF SE, SP value of 7.5) in cyclohexane was applied to the counter electrode of the obtained laminate to form an encapsulation resin layer with a thickness of 10 μm, thereby encapsulating the laminate to provide a solar cell.

(Reference Examples

2 to 5, Comparative Examples 1 to 3)

A solar cell was obtained in the same manner as in Example 1, except that the hole transport layer and the encapsulation resin layer were formed as shown in Table 1.

<Evaluation 1>

The solar cells obtained in Examples 1 to 5 and Comparative Examples 1 to 3 were evaluated for the following parameters. Table 1 shows the results.

(1) Photoelectric conversion efficiency

A power source (236 model, available from Keithley Instruments Inc.) was connected between the electrodes of the solar cell. The photoelectric conversion efficiency was measured using a solar simulator (available from Yamashita Denso Corp.) having an intensity of 100 mW/cm$^2$, and the obtained value was taken as the initial conversion efficiency. The obtained values were evaluated based on the following criteria.

◦ (Good): The value of the initial photoelectric conversion efficiency was 10% or higher.
× (Poor): The value of the initial photoelectric conversion efficiency was lower than 10%.

(2) High-temperature durability

The solar cell was left on an electric griddle at a temperature of 90°C for 300 hours in an environment of a dew point of -10°C for a high-temperature durability test. A power source (236 model, available from Keithley Instruments Inc.) was connected between the electrodes of the solar cell after the high-temperature durability test. The photoelectric conversion efficiency was measured using a solar simulator (available from Yamashita Denso Corp.) having an intensity of 100 mW/cm$^2$, and the value of (photoelectric conversion efficiency after the high-temperature durability test)/(initial conversion efficiency obtained above) was calculated. The obtained value was evaluated based on the following criteria.

◦ (Good): The value of (photoelectric conversion efficiency after the high-temperature durability test)/(initial conversion efficiency) was 0.8 or more.
△ (Average): The value of (photoelectric conversion efficiency after the high-temperature durability test)/(initial conversion efficiency) was 0.5 or more and less than 0.8.
x (Poor): The value of (photoelectric conversion efficiency after the high-temperature durability test)/(initial conversion efficiency) was less than 0.5.

[Table 1]

| | Hole transport layer | | | | | Encapsulation resin layer | | Evaluation | |
|---|---|---|---|---|---|---|---|---|---|
| | Structure | | | Amount of ionic compound (% by weight) | Metal concentration (ppm) | Material | SP value | Photoelectric conversion efficiency | High-temperature durability |
| | Ionic compound of spiro compound cation | Other material | Additive | | | | | | |
| Example 1 | Spiro-OMe TAD-TFSI ionic compound | Spiro-OMeTAD | - | 10 | 800 | Polyisobutylene | 7.5 | ○ | ○ |
| Example 2 | Spiro-OMeTAD-TFSI ionic compound | Spiro-OMeTAD | - | 5 | 400 | Polycycloolefin | 8.9 | ○ | ○ |
| Example 3 | Spiro-OMe TAD-TFSI ionic compound | Spiro-OMeTAD | - | 10 | 800 | Polyisobomyl methacrylate | 9.2 | ○ | ○ |
| Example 4 | Spiro-OMe TAD-TFSI ionic compound | Spiro-OMeTAD | - | 10 | 800 | Not used | - | ○ | △ |
| Example 5 | Spiro-OMe TAD-TFSI ionic compound | Spiro-OMeTAD | - | 10 | 800 | Polymethyl acrylate | 10.1 | ○ | △ |
| Comparative Example 1 | - | Spiro-OMeTAD | Li-TFSI | - | 11000 | Polyisobutylene | 7.5 | ○ | x |
| Comparative Example 2 | - | Spiro-OMeTAD | Li-TFSI | - | 11000 | Not used | - | ○ | x |
| Comparative Example 3 | - | Spiro-OMeTAD | - | - | - | Not used | - | x | x |

(Reference Example 6)

A FTO film having a thickness of 1,000 nm was formed as an electrode on a glass substrate, ultrasonically washed with pure water, acetone, and methanol each for ten minutes in the stated order, and then dried.

A solution of titanium isopropoxide in ethanol adjusted to 2% was applied to the surface of the FTO film by the spin coating method and then fired at 400°C for 10 minutes to form a thin film-like electron transport layer having a thickness of 20 nm. A titanium oxide paste containing polyisobutyl methacrylate as an organic binder and titanium oxide (mixture of powders having average particle sizes of 10 nm and 30 nm) was further applied to the thin film-like electron transport layer by the spin coating method and then fired at 500°C for 10 minutes to form a porous electron transport layer having a thickness of 500 nm.

Separately, lead iodide was reacted with dimethyl sulfoxide (DMSO) in advance to prepare a lead iodide-dimethyl sulfoxide complex. The lead iodide-dimethyl sulfoxide complex was dissolved in N,N-dimethylformamide (DMF) at a concentration of 40% by weight to prepare a coating solution.

On the electron transport layer was laminated the obtained coating solution by the spin coating method to a thickness of 500 nm, and a 8% solution of methylammonium iodide in isopropanol was applied thereto by the spin coating method so that the coating solution was reacted. A photoelectric conversion layer containing an organic-inorganic perovskite compound was thus formed.

Next, 0.25 g of poly[bis(4-phenyl)(4-butyl phenyl)amine](Poly-TPD, available from 1-Material, number average molecular weight of 20000) and 0.17 g of silver trifluorosulfonylimide (Ag-TFSI, available from Aldrich) were dissolved in 25 mL of dichloromethane, and stirred at 500 rpm for 24 hours. The resulting solution was passed through a 1-μm mesh to separate precipitates, and the recovered solution was concentrated using an evaporator. The resulting concentrate was recrystallized using diethyl ether, thereby preparing an ionic compound containing a Poly-TPD cation and a TFSI anion. An amount of 1 mg of the obtained ionic compound and 9 mg of the Poly-TPD were dissolved in 500 μL of chlorobenzene, and the obtained solution was applied by the spin coating method to form a hole transport layer containing 10% by weight of the ionic compound.

The presence of the ionic bond formed by PolyTPD and TFSI was confirmed as follows. The absorption spectrum was measured to find a shift of the absorption to the long wavelength side in comparison to the spectrum of the sample in which no ionic bond was formed. The metal concentration (silver concentration) of the hole transport layer measured by ICP-MS (available from Shimadzu Corporation) was 80 ppm.

On the obtained hole transport layer were formed an ITO film with a thickness of 100 nm as a counter electrode by vacuum deposition. Thus, a solar cell in which an electrode, an electron transport layer, a photoelectric conversion layer, a hole transport layer, and a counter electrode were stacked was obtained.

(Inventive Example 7)

A solar cell was obtained in the same manner as in Example 6, except that, in formation of the hole transport layer, poly[bis(4-phenyl)(2,4,6-trimethyl phenyl)amine] (PTAA-3Me, available from Aldrich, number average molecular weight of 7000) was used instead of PolyTPD.

(Inventive Example 8)

A solar cell was obtained in the same manner as in Example 6, except that, in formation of the hole transport layer, poly[bis(4-phenyl)(2,4-dimethyl phenyl)amine] (PTAA-2Me, available from EM-index, number average molecular weight of 22000) was used instead of PolyTPD.

(Inventive Example 9)

A solar cell was obtained in the same manner as in Example 6, except that, in formation of the hole transport layer, an ionic compound containing a thiophene compound cation represented by the following formula (a) and a TFSI anion was obtained by using a thiophene compound (P3HT, available from Aldrich, number average molecular weight of 50,000) instead of PolyTPD.

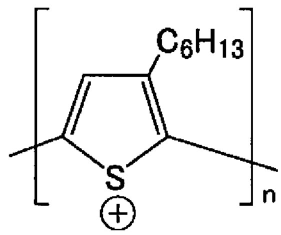

(a)

(Inventive Example 10)

A solar cell was obtained in the same manner as in Example 6, except that, in formation of the hole transport layer, an ionic compound containing a thiophene compound cation represented by the following formula (b) and a TFSI anion was obtained by using a thiophene compound (DR3, available from 1-Material) instead of PolyTPD.

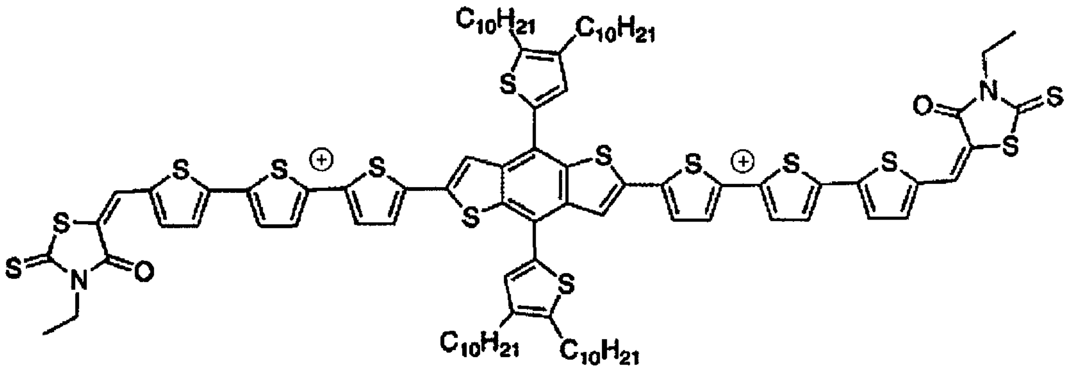

(b)

(Inventive Example 11)

A solar cell was obtained in the same manner as in Example 6, except that, in formation of the hole transport layer, an ionic compound containing a thiophene compound cation represented by the following formula (c) and a TFSI anion was obtained by using a thiophene compound (P3OT, available from Aldrich, number average molecular weight of 50000) instead of PolyTPD.

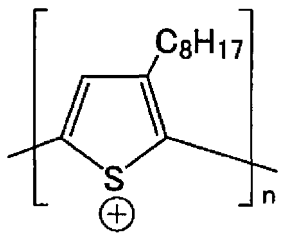

(c)

(Inventive Example 12)

A solar cell was obtained in the same manner as in Example 6, except that, in formation of the hole transport layer, an ionic compound containing a thiophene compound cation represented by the following formula (d) and a TFSI anion was obtained by using a thiophene compound (DH6T, available from Aldrich) instead of PolyTPD.

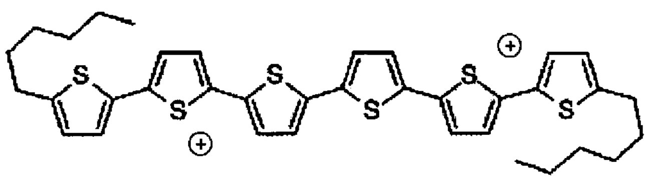

(d)

(Reference Example

A solar cell was obtained in the same manner as in Example 6, except that, in formation of the hole transport layer, 2,2',7,7'-tetrakis-(N,N-di-methoxyphenyl amine)-9,9'-spirobifluorene (Spiro-OMeTAD) was used instead of Poly-TPD.

(Comparative Example 4)

A solar cell was obtained in the same manner as in Example 6, except that, in formation of the hole transport layer, the TFSI/silver salt was not used.

(Comparative Example 5)

A solar cell was obtained in the same manner as in Example 6, except that the hole transport layer was formed by dissolving 10 mg of Poly-TPD, 7.5 μL of a solution of Li-bis(TFSI) in acetonitrile (170 mg/1 mL), and 4 μL of t-butylpyridine in 1 mL of chlorobenzene and applying the obtained solution by spin coating.
The metal concentration (lithium concentration) of the hole transport layer measured by ICP-MS was 2500 ppm.

(Comparative Example 6)

A solar cell was obtained in the same manner as in Example 9, except that, in formation of the hole transport layer, the TFSI/silver salt was not used.

(Comparative Example 7)

A solar cell was obtained in the same manner as in Example 6, except that the hole transport layer was formed by dissolving 40 mg of a thiophene compound (DR3, available from 1-Material) represented by the formula (b), 20 μL of a solution of Li-bis(TFSI) in acetonitrile (170 mg/1 mL), and 5 μL of t-butylpyridine in 1 mL of chlorobenzene and applying the obtained solution by spin coating.
The metal concentration (lithium concentration) of the hole transport layer measured by ICP-MS was 11000 ppm.

(Comparative Example 8)

A solar cell was obtained in the same manner as in Example 6, except that the hole transport layer was formed by dissolving 90 mg of Spiro-OMeTAD, 45 μL of a solution of Li-bis(TFSI) in acetonitrile (170 mg/1 mL), and 10 μL of t-butylpyridine were dissolved in 1 mL of chlorobenzene and applying the obtained solution by spin coating.
The metal concentration (lithium concentration) of the hole transport layer measured by ICP-MS was 11000 ppm.

<Evaluation 2>

The solar cells obtained in Examples 6 to 13 and Comparative Examples 4 to 8 were evaluated for the following parameters.
Table 2 shows the results.

(1) Photoelectric conversion efficiency

A power source (236 model, available from Keithley Instruments Inc.) was connected between the electrodes of the solar cell. The photoelectric conversion efficiency was measured using a solar simulator (available from Yamashita Denso Corp.) having an intensity of 100 mW/$cm^2$, and the obtained value was taken as the initial conversion efficiency. The obtained values were normalized based on the initial conversion efficiency of the solar cell obtained in Comparative Example 8 as the standard.

∘ (Good): The value of the normalized photoelectric conversion efficiency was 0.8 or more.
△ (Average): The value of the normalized photoelectric conversion efficiency was 0.7 or more and less than 0.8.
x (Poor): The value of the normalized photoelectric conversion efficiency was less than 0.7.

(2) High-temperature durability

The solar cell was left on an electric griddle at a temperature of 90°C for 300 hours in an environment of a dew point of -10°C for a high-temperature durability test. A power source (236 model, available from Keithley Instruments Inc.) was connected between the electrodes of the solar cell after the high-temperature durability test. The photoelectric conversion efficiency was measured using a solar simulator (available from Yamashita Denso Corp.) having an intensity of 100 $mW/cm^2$, and the value of (photoelectric conversion efficiency after the high-temperature durability test)/(initial conversion efficiency obtained above) was calculated. The obtained value was evaluated based on the following criteria.

◦ (Good): The value of (photoelectric conversion efficiency after the high-temperature durability test)/(initial conversion efficiency) was 0.8 or more.
△ (Average): The value of (photoelectric conversion efficiency after the high-temperature durability test)/(initial conversion efficiency) was 0.5 or more and less than 0.8.
× (Poor): The value of (photoelectric conversion efficiency after the high-temperature durability test)/(initial conversion efficiency) was less than 0.5.

[Table 2]

| | Hole transport layer | | | | | | | Evaluation | |
|---|---|---|---|---|---|---|---|---|---|
| | Structure | | | | | Amount of ionic compound (by weight) | Metal concentration (ppm) | Photoelectric conversion efficiency | High-temperature durability |
| | Ionic compound of polytriphenylamine compound cation | Ionic compound of thiophene compound cation | Ionic compound of spiro compound cation | Other material | Additive | | | | |
| Example 6 | PolyTPD-TFSI ionic compound | - | - | - | - | 10% | 80 | ○ | ○ |
| Example 7 | PTAA-3Me-TFSI ionic compound | - | - | - | - | 10% | 40 | ○ | ○ |
| Example 8 | PTAA-2Me-TFSI ionic compound | - | - | - | - | 10% | 50 | ○ | ○ |
| Example 9 | - | P3HT-TFSI ionic compound | - | - | - | 10% | 40 | ○ | ○ |
| Example 10 | - | DR3-TFSI ionic compound | - | - | - | 10% | 40 | ○ | ○ |
| Example 11 | - | P30T-TFSI ionic compound | - | - | - | 10% | 40 | ○ | ○ |
| Example 12 | - | DH6T-TFSI ionic compound | - | - | - | 10% | 40 | ○ | ○ |
| Example 13 | - | - | Spiro-OMe TAD-TFSI ionic compound | - | - | 10% | 80 | ○ | △ |
| Comparative Example 4 | - | - | - | PolyTPD | - | - | 0 | x | ○ |
| Comparative Example 5 | - | - | - | PolyTPD | Li-TFSI | - | 2500 | △ | x |
| Comparative Example 6 | - | - | - | P3HT | - | - | 0 | x | ○ |

(continued)

| | Hole transport layer | | | | | | | Evaluation | |
|---|---|---|---|---|---|---|---|---|---|
| | Structure | | | | | Amount of ionic compound (by weight) | Metal concentration (ppm) | Photoelectric conversion efficiency | High-temperature durability |
| | Ionic compound of polytriphenylamine compound cation | Ionic compound of thiophene compound cation | Ionic compound of spiro compound cation | Other material | Additive | | | | |
| Comparative Example 7 | - | - | - | DR3 | Li-TFSI | - | 11000 | △ | x |
| Comparative Example 8 | - | - | - | Spiro-OMeTAD | Li-TFSI | - | 11000 | - | x |

INDUSTRIAL APPLICABILITY

The present invention can provide a solar cell having high photoelectric conversion efficiency and excellent high-temperature durability.

## Claims

1. **1.** A solar cell comprising:

   an electrode;
   a counter electrode;
   a photoelectric conversion layer disposed between the electrode and the counter electrode; and
   a hole transport layer disposed between the photoelectric conversion layer and the counter electrode,
   the hole transport layer containing an ionic compound that contains an organic semiconductor cation and a fluorine-containing compound anion, wherein
   the organic semiconductor cation is a polytriphenylamine compound cation represented by the formula (3), or a thiophene compound cation having a structure represented by the formula (4):

   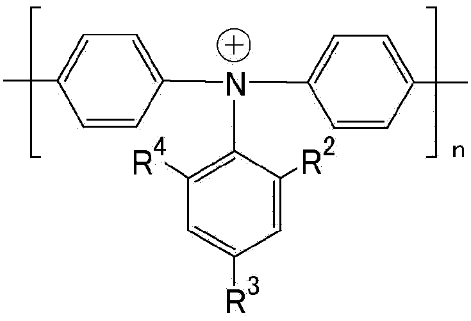

   (3)

   where $R^2$, $R^3$, and $R^4$ each represent hydrogen, an alkyl group, an aryl group optionally having a substituent, a carboxyl group, a carbonyl group, an alkoxy group, an ester group,
   or an amino group, and any of $R^2$, $R^3$, and $R^4$ may be bonded to each other to form a ring structure, and n represents an integer;

   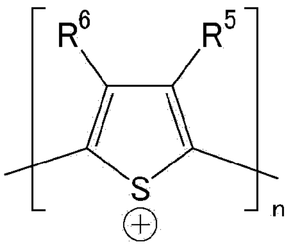

   (4)

   where $R^5$ and $R^6$ each represent hydrogen, an alkyl group, an aryl group optionally having a substituent, a carboxyl group, a carbonyl group, an alkoxy group, an ester group, or an amino group, and $R^5$ and $R^6$ may be bonded to each other to form a ring structure, and n represents an integer, **characterised in that** the hole transport layer has a metal concentration of 1000 ppm or lower.

2. **2.** The solar cell according to claim 1,
   wherein the fluorine-containing compound anion is an anion represented by the formula (5-1), an anion represented by the formula (5-2), an anion represented by the formula (5-3), an anion represented by the formula (5-4), an anion represented by the formula (5-5), or an anion represented by the formula (5-6):

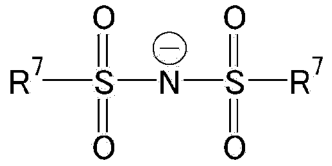

(5-1) ,

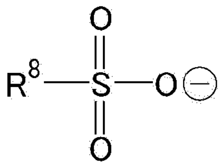

(5-2) ,

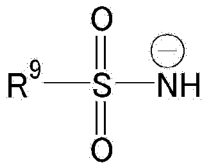

(5-3) ,

**$PF_5^-$ (5-4),**

**$BF_4^-$ (5-5),**

**$SbF_6^-$ (5-6)**,

where $R^7$ to $R^9$ each represent an alkyl group partly or entirely substituted with fluorine in the formulae (5-1) to (5-3), and one $R^7$ and the other $R^7$ in the formula (5-1) may be bonded to each other to form a ring structure.

**3.** The solar cell according to claim 1 or 2,
wherein the photoelectric conversion layer contains an organic-inorganic perovskite compound represented by the formula: $R\text{-}M\text{-}X_3$ where R represents an organic molecule, M represents a metallic atom, and X represents a halogen or chalcogen atom.

**4.** The solar cell according to claim 1, 2 or 3, further comprising

an encapsulation resin layer covering the counter electrode,
the encapsulation resin layer encapsulating a laminate having at least the electrode, the counter electrode, the photoelectric conversion layer disposed between the electrode and the counter electrode, and the hole transport layer disposed between the photoelectric conversion layer and the counter electrode.

**5.** The solar cell according to claim 4,
wherein the encapsulation resin layer is formed of a resin having a solubility parameter (SP value) of 10 or less determined based on the evaporation energy (Δecoh) (cal/mol) and molar volume (Δv) ($cm^3$/mol) of each atomic group in repeating units or the structure of the resin using equation (1), wherein δ represents the SP value $(cal/mol)^{1/2}$:

$$\delta = \sqrt{\frac{\sum \Delta ecoh}{\sum \Delta v}} \qquad (1)$$

and adding, in the case of Tg ≥ 25°C, 2n to Δv when n ≥ 3 is satisfied and 4n is added to Δv when n < 3 is satisfied, n representing the number of main chain atoms.

**Patentansprüche**

1. Solarzelle, umfassend:

eine Elektrode,
eine Gegenelektrode,
eine fotoelektrische Umwandlungsschicht, die zwischen der Elektrode und der Gegenelektrode angeordnet ist, und
ein Lochtransportschicht, die zwischen der fotoelektrischen Umwandlungsschicht und der Gegenelektrode angeordnet ist,
wobei die Lochtransportschicht eine ionische Verbindung enthält, die ein organisches Halbleiter-Kation und ein Anion in Form einer Fluor enthaltenden Verbindung enthält,
wobei
das organische Halbleiter-Kation ein Kation in Form einer Polytriphenylamin-Verbindung, die durch die Formel (3) dargestellt wird, oder ein Kation in Form einer Thiophen-Verbindung ist, welche die durch die Formel (4) dargestellte Struktur aufweist:

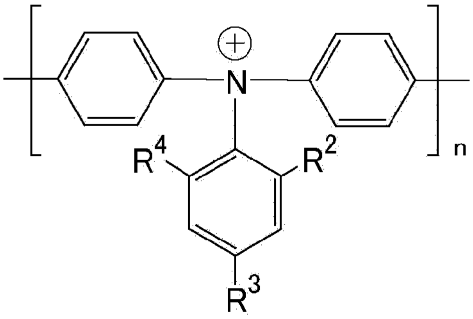

(3)

wobei $R^2$, $R^3$ und $R^4$ jeweils Wasserstoff, eine Alkylgruppe, eine Arylgruppe, die optional einen Substituenten aufweist, eine Carboxylgruppe, eine Carbonylgruppe, eine Alkoxygruppe, eine Estergruppe oder eine Aminogruppe darstellen, und $R^2$, $R^3$ und $R^4$ jeweils beliebig aneinander gebunden sein können, um eine Ringstruktur zu bilden, und n eine ganze Zahl darstellt,

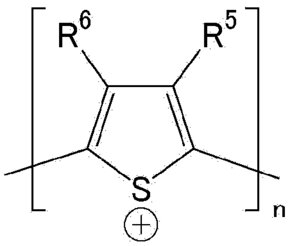

(4)

wobei $R^5$ und $R^6$ jeweils Wasserstoff, eine Alkylgruppe, eine Arylgruppe, die optional einen Substituenten aufweist, eine Carboxylgruppe, eine Carbonylgruppe, eine Alkoxygruppe, eine Estergruppe oder eine Aminogruppe darstellen, und $R^5$ und $R^6$ aneinander gebunden sein können, um eine Ringstruktur zu bilden, und n eine ganze Zahl darstellt, **dadurch gekennzeichnet, dass** die Lochtransportschicht eine Metallkonzentration von 1.000 ppm oder weniger aufweist.

2. Solarzelle nach Anspruch 1,
wobei das Anion in Form einer Fluor enthaltenden Verbindung ein Anion ist, das durch die Formel (5-1) dargestellt wird, ein Anion, das durch die Formel (5-2) dargestellt wird, ein Anion, das durch die Formel (5-3) dargestellt wird, ein Anion, das durch die Formel (5-4) dargestellt wird, ein Anion, das durch die Formel (5-5) dargestellt wird, oder ein Anion, das durch die Formel (5-6) dargestellt wird:

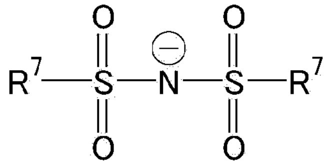

(5-1) ,

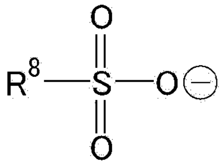

(5-2) ,

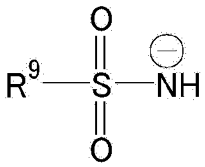

(5-3) ,

$PF_5^-$ (5-4)

,

$BF_4^-$ (5-5)

,

$SbF_6^-$ (5-6)

, wobei $R^7$ bis $R^9$ jeweils eine Alkylgruppe darstellen, die in den Formeln (5-1) bis (5-3) teilweise oder vollständig mit Fluor substituiert ist, und ein $R^7$ und das andere $R^7$ in der Formel (5-1) aneinander gebunden sein können, um eine Ringstruktur zu bilden.

**3.** Solarzelle nach Anspruch 1 oder Anspruch 2,
wobei die fotoelektrische Umwandlungsschicht eine organisch-anorganische Perowskit-Verbindung enthält, die durch die Formel dargestellt wird: $R\text{-}M\text{-}X_3$ wobei R ein organisches Molekül darstellt, M ein Metallatom darstellt, und X ein Halogen oder Chalkogen-Atom darstellt.

**4.** Solarzelle nach Anspruch 1, 2 oder 3, ferner umfassend

eine Harz-Einkapselungsschicht, welche die Gegenelektrode bedeckt,
wobei die Harz-Einkapselungsschicht ein Laminat einkapselt, das zumindest die Elektrode, die Gegenelektrode, die fotoelektrische Umwandlungsschicht, die zwischen der Elektrode und der Gegenelektrode angeordnet ist, und die Lochtransportschicht, die zwischen der fotoelektrischen Umwandlungsschicht und der Gegenelektrode angeordnet ist, aufweist.

**5.** Solarzelle nach Anspruch 4,
wobei die Harz-Einkapselungsschicht aus einem Harz gebildet ist, das einen Löslichkeitsparameter (SP-Wert) von 10 oder weniger aufweist, bestimmt auf Grundlage der Verdampfungsenergie ($\Delta$ecoh) (cal/mol) und des molaren Volumens ($\Delta$v) ($cm^3$/mol) jeder atomaren Gruppe in sich wiederholenden Einheiten oder der Struktur des Harzes unter Verwendung der Gleichung (1), wobei $\delta$ den SP-Wert $(cal/mol)^{1/2}$ darstellt:

$$\delta = \sqrt{\frac{\sum \Delta ecoh}{\sum \Delta v}} \qquad (1)$$

und durch Hinzufügen, im Fall von Tg ≥ 25 °C, 2n zu Δv, wenn n ≥ 3 erfüllt ist, und 4n zu Δv hinzugefügt wird, wenn n < 3 erfüllt wird, wobei n die Anzahl der Hauptkettenatome darstellt.

**Revendications**

**1.** Cellule photovoltaïque comprenant :

une électrode ;
une contre-électrode ;
une couche de conversion photoélectrique disposée entre l'électrode et la contre-électrode ; et
une couche de transport de trous disposée entre la couche de conversion photoélectrique et la contre-électrode, la couche de transport de trous contenant un composé ionique qui contient un cation de semi-conducteur organique et un anion de composé contenant du fluor,
dans laquelle le cation de semi-conducteur organique est un cation de composé de polytriphénylamine représenté par la formule (3), où un cation de composé de thiophène présentant une structure représentée par la formule (4) :

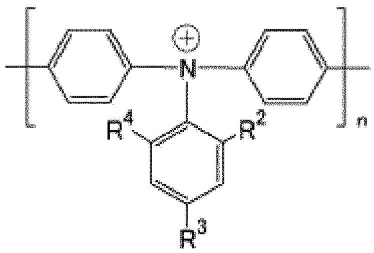

(3)

où $R^2$, $R^3$ et $R^4$ représentent chacun l'hydrogène, un groupe alkyle, un groupe aryle présentant éventuellement un substituant, un groupe carboxyle, un groupe carbonyle, un groupe alcoxy, un groupe ester, ou un groupe amino, et l'un quelconque de $R^2$, $R^3$, et $R^4$ peut être lié à l'autre pour former une structure de noyau, et n représente un nombre entier ;

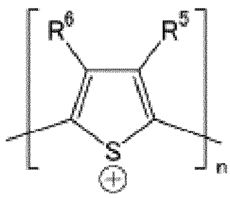

(4)

où $R^5$ et $R^6$ représentent chacun l'hydrogène, un groupe alkyle, un groupe aryle présentant éventuellement un substituant, un groupe carboxyle, un groupe carbonyle, un groupe alcoxy, un groupe ester, ou un groupe amino, et $R^5$ et $R^6$ peuvent être liés l'un à l'autre pour former un cycle, et n représente un nombre entier, **caractérisée en ce que** la couche de transport de trous présente une concentration en métal de 1 000 ppm ou inférieure.

**2.** Cellule photovoltaïque selon la revendication 1,
dans laquelle l'anion de composé contenant du fluor est un anion représenté par la formule (5-1), un anion représenté par la formule (5-2), un anion représenté par la formule (5-3), un anion représenté par la formule (5-4), un anion représenté par la formule (5-5), ou un anion représenté par la formule (5-6) :

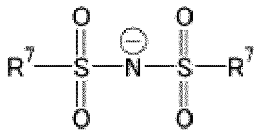

(5-1) ,

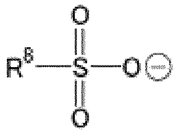

(5-2) ,

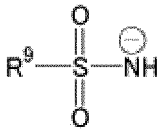

(5-3) ,

$PF_5^-$ (5-4)

,

$BF_4^-$ (5-5)

,

$SbF_6^-$ (5-6)

, où $R^7$ à $R^9$ représentent chacun un groupe alkyle partiellement ou entièrement substitué avec du fluor dans les formules (5-1) à (5-3), et un $R^7$ et l'autre $R^7$ dans la formule (5-1) peuvent être liés l'un à l'autre pour former un cycle.

**3.** Cellule photovoltaïque selon la revendication 1 ou 2,
dans laquelle la couche de conversion photoélectrique contient un composé de pérovskite organique-inorganique représenté par la formule : $R\text{-}M\text{-}X_3$ où R représente une molécule organique, M représente un atome métallique, et X représente un atome d'halogène ou de chalcogène.

**4.** Cellule photovoltaïque selon la revendication 1, 2 ou 3, comprenant de plus

une couche de résine d'encapsulation recouvrant la contre-électrode,
la couche de résine d'encapsulation encapsulant un stratifié présentant au moins l'électrode, la contre-électrode, la couche de conversion photoélectrique disposée entre l'électrode et la contre-électrode, et la couche de transport de trous disposée entre la couche de conversion photoélectrique et la contre-électrode.

**5.** Cellule photovoltaïque selon la revendication 4,
dans laquelle la couche de résine d'encapsulation est formée d'une résine présentant un paramètre de solubilité (valeur SP) de 10 ou inférieur déterminé sur la base des énergie d'évaporation ($\Delta$ecoh) (cal/mol) et volume molaire ($\Delta$v) ($cm^3$/mol) de chaque groupe atomique dans des unités répétitives ou la structure de la résine en utilisant l'équation (1), dans laquelle $\delta$ représente la valeur SP $(cal/mol)^{1/2}$ :

$$\delta = \sqrt{\frac{\sum \Delta ecoh}{\sum \Delta v}} \qquad (1)$$

et en ajoutant, dans le cas de $Tg \geq 25°C$, 2n à $\Delta$v lorsque $n \geq 3$ est satisfait et 4n est ajouté à $\Delta$v lorsque $n < 3$ est satisfait,
n représentant le nombre d'atomes de chaîne principale.

FIG.1

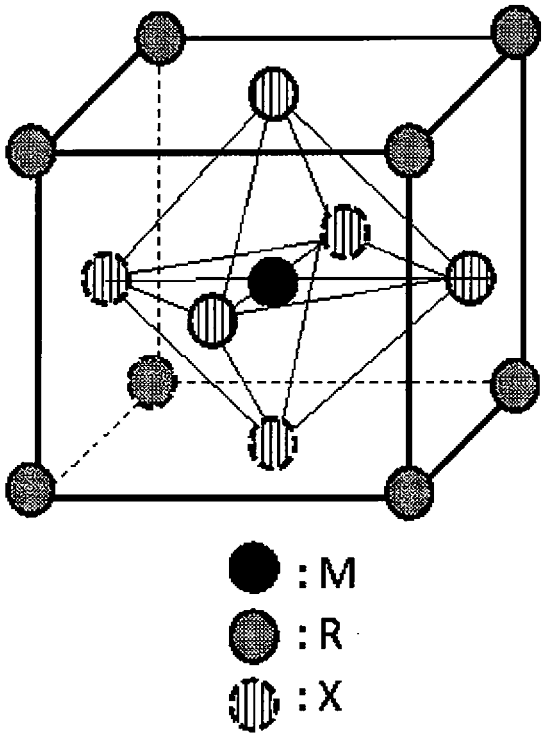

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006344794 A
- JP 4120362 B
- JP 2006237283 A


### Non-patent literature cited in the description


- **ANTONIO ABATE et al.** Protic Ionic Liquids as p-Dopant for Organic Hole Transporting Materials and Their Application in High Efficiency Hybrid Solar Cells. *Journal of the American Chemical Society,* 25 July 2013, vol. 135 (36), 13538-13548
- **WILLIAM NGUYEN et al.** Enhancing the Hole-Conductivity of Spiro-OMeTAD without Oxygen or Lithium Salts by Using Spiro(TFSI)2 in Perovskite and Dye-Sensitized Solar Cells. *JACS,* 22 July 2014, vol. 136, 10996-11001
- **R.F. FEDORS.** *Polym. Eng. Sci.,* 1974, vol. 14 (2), 147-154
- **J. BRANDRUP et al.** Polymer Handbook. vol. 2